# EUROPEAN PATENT APPLICATION

(11) **EP 2 120 511 A1**
(43) Date of publication of application: **18.11.2009**
(21) Application number: 08711386.6
(22) Date of filing: 15.02.2008
(51) Int. Cl.: H05B 37/02, G02F 1/133, H01L 31/12, H01L 33/00

(54) **LIGHT SOURCE DEVICE AND LIQUID CRYSTAL DISPLAY DEVICE**

(30) Priority: 23.02.2007 JP 2007044300
(71) Applicant: Sony Corporation, Tokyo 108-0075 (JP)
(72) Inventor: OKABE, Mitsuru, Tokyo 108-0075 (JP)
(74) Representative: Thévenet, Jean-Bruno
(86) International application number: PCT/JP2008/052556
(87) International publication number: WO 2008/102707

(57) **Abstract**

A light source device capable of improving detection precision of illuminated light in the light source device performing partial lighting operation is provided. In the case of lighting number variable operation mode, a backlight control section 12 exercises control so that a pulse width ΔT of the last pulse signal out of a plurality of pulse signals generated in one frame time period is a threshold value T2 (Tth) or less. In the case where the light emission luminance of a partial lighting section 4 is high (in the case where the width of the plurality of pulse signals is respectively wide), interference between a light receiving signal obtained in a partial lighting time period Δt1 and a light receiving signal obtained in the whole lighting time period Δt4 is able to be avoided. Therefore, variation of the signal value depending on detection timing of the obtained light receiving signal is avoided, and detection precision is improved.

## Description

### TECHNICAL FIELD

The present invention relates to a light source device having a plurality of partial lighting regions each of which is controlled separately, and a liquid crystal display unit using such a light source device.

### BACKGROUND ART

Currently, as typified by a liquid crystal TV and a Plasma Display Panel (PDP), there is a trend toward a thin display. Specially, many mobile-use displays are liquid crystal system displays, being desired to realize accurate color reproducibility. Further, as a backlight of a liquid crystal panel, a Cold Cathode Fluorescent Lamp (CCFL) type using a fluorescence tube is the main stream. However, less mercury is demanded environmentally, and thus as a light source alternative to the CCFL, a Light Emitting Diode (LED) and the like are prospective.

As a backlight device using such an LED, the backlight devices described in, for example, Patent documents 1 and 2 have been proposed. In the LED backlight device described in Patent document 1, the luminance level of the whole backlight device is changed according to lightness of surrounding environment by detecting outside light. Meanwhile, in the LED backlight device described in Patent document 2, to improve video response of a liquid crystal panel, a light source section is divided into a plurality of partial lighting sections, lighting operation is sequentially performed by the plurality of partial lighting sections, and thereby so-called black insertion processing is performed.

[Patent Document 1] Japanese Unexamined Patent Application Publication No. 2006-145886
[Patent Document 2] Japanese Unexamined Patent Application Publication No. 2006-243283

### DISCLOSURE OF INVENTION

Now, in the LED backlight device as described above, illuminated light is detected and a light emission quantity of the LED is controlled based on the detected value, and thereby luminance change of the illuminated light is able to be inhibited. Further, in an additive color mixture type backlight device in which a plurality of types of LEDs such as a red LED, a green LED, and a blue LED are used and a plurality of color light are mixed to obtain specific color light, in addition to the luminance change of the illuminated light, chromaticity change of the illuminated light is also inhibited by a similar feedback system.

However, in the case where the light emission quantity of the LED is controlled by the feedback system using a photoreception device, there is a disadvantage as follows. That is, in the backlight device that performs lighting operation by using the plurality of partial lighting sections, a signal value varies according to timing of sampling a photoreception signal obtained by the photoreception device, and thus detection precision of the illuminated light is lowered.

Specifically, in general, one photoreception device is provided for a detection region configured of the plurality of partial lighting sections. Further, in general, the all partial lighting sections are lighted in the detection region (in a state of whole lighting). Meanwhile, in sampling the photoreception signal for adjusting luminance and chromaticity of the illuminated light, only one partial lighting section is lighted in the detection region (in a state of partial lighting), and light from the partial lighting section is sampled. Further, in general, light emission luminance (light emission quantity) in the respective partial lighting sections is PWM (Pulse Width Modulation)-controlled by using a pulse signal. Therefore, the size of a photoreception signal in the time period in a state of whole lighting (whole lighting time period) is different from the size of a photoreception signal in the time period in a state of partial lighting (partial lighting time period). Thus, in the case where the light emission luminance of the partial lighting section is high (width of the pulse signal is wide), the photoreception signal obtained in the whole lighting time period and the photoreception signal obtained in the partial lighting time period interfere with each other in some cases. In this case, the signal value varies according to timing of sampling the obtained photoreception signal, and thus detection precision of the illuminated light is lowered.

As described above, in the conventional technology, it has been difficult to improve the detection precision of the illuminated light in the light source device that performs partial lighting operation by using the plurality of partial lighting sections.

In view of the foregoing disadvantage, it is an object of the present invention to provide a light source device capable of improving detection precision of illuminated light in the light source device performing partial lighting operation and a liquid crystal display unit including such a light source device.

A light source device of the present invention includes: a light source section having a plurality of partial lighting sections, each of the partial lighting sections being controlled separately; a drive means; a photoreception device receiving light from the light source section; and a sampling means. Here, the foregoing drive means time-divisionally drives the light source section with a pulse signal so that a whole lighting time period and a partial lighting time period are mixed along time base. In the drive means, all of the partial lighting sections are lighted in the whole lighting time period, and only one part of the partial lighting sections is lighted in the partial lighting time period. In addition, the drive means performs control so that a width of the pulse signal generated immediately before a transition from the whole lighting time period to the partial lighting time period are equal to or less than a given threshold value. Further, the foregoing sampling means samples, at a timing in the partial lighting time period, a photoreception signal obtained by the photoreception device.

A liquid crystal display unit of the present invention includes an illuminating means for emitting light and a liquid crystal panel modulating the light emitted from the illuminating means based on a picture signal. The foregoing illuminating means has the foregoing light source section, the foregoing drive means, the foregoing photoreception device, and the foregoing sampling means.

In the light source device and the liquid crystal display unit of the present invention, the light source section is time-divisionally driven by a pulse signal so that the whole lighting time period and the partial lighting time period are mixed along time base, and light from the light source section is received by the photoreception device. The width of the pulse signal (last pulse signal) generated immediately before a transition from the whole lighting time period to the partial lighting time period are equal to or less than a given threshold value, and the photoreception signal obtained by the photoreception device is sampled at a timing in the partial lighting time period. Thus, even if the light emission luminance of the partial lighting section is set high (even if the width of the foregoing last pulse signal is set to be wider than the threshold value), the width of the last pulse signal is forcefully the threshold value or less. Therefore, interference between the photoreception signal obtained in the whole lighting time period and the photoreception signal obtained in the last partial lighting time period is able to be avoided. Accordingly, a signal value of the photoreception signal in the partial lighting time period is able to be almost constant not depending on sampling timing in the partial lighting time period.

In the light source device of the present invention, the foregoing drive means may perform control so that the light emission quantity of each of the partial lighting sections is respectively kept constant based on the photoreception signal sampled by the sampling means in the partial lighting time period. In this case, the light emission quantity of each of the partial lighting sections is respectively controlled based on the photoreception signal in the partial lighting time period whose value is kept almost constant not depending on sampling timing, and thus precision to keep the light emission quantity constant is improved. Further, the foregoing drive means may perform control so that the light emission quantity of the one part of the partial lighting sections is respectively kept constant based on the photoreception signal sampled by the sampling means in the partial lighting time period, and the foregoing drive means may drive the light source section so that the one part of the partial lighting sections circularly travels in the plurality of partial lighting sections. In this case, again, the light emission quantity of the foregoing one part of the partial lighting sections is respectively controlled based on the photoreception signal in the partial lighting time period whose value is kept almost constant not depending on sampling timing, and thus precision to keep the light emission quantity constant is improved. Further, since the one part of the partial lighting sections whose light emission quantity is the control target circularly travels in the plurality of partial lighting sections, light emission quantities of the all partial lighting sections are controlled based on their own illuminated light. Accordingly, fine light emission quantity control for the respective partial lighting sections is enabled, and precision to keep the light emission quantity constant as the whose light source section is more improved.

In the light source device of the present invention, the foregoing drive means preferably performs configuration so that the threshold value decreases as a frequency of the pulse signal increases. In this case, it is possible to address a case that the frequency of the pulse signal is changed. Thus, even if the frequency is high, interference between the photoreception signal in the whole lighting time period and the photoreception signal in the partial lighting time period is able to be avoided.

According to the light source device or the liquid crystal display unit of the present invention, the light source section is time-divisionally driven by the pulse signal so that the whole lighting time period and the partial lighting time period are mixed along time base, and light from the light source section is received by the photoreception device. The width of the pulse signal (last pulse signal) generated immediately before the transition from the whole lighting time period to the partial lighting time period are equal to or less than the given threshold value, and the photoreception signal obtained by the photoreception device is sampled at the timing in the partial lighting time period. Thus, even if the light emission luminance of the partial lighting section is set high (even if the width of the foregoing last pulse signal is set to be wider than the threshold value), interference between the photoreception signal obtained in the whole lighting time period and the photoreception signal obtained in the last partial lighting time period is able to be avoided. Accordingly, a signal value of the photoreception signal in the partial lighting time period is able to be almost constant not depending on sampling timing in the partial lighting time period, and detection precision of illuminated light is able to be improved in the light source device performing partial lighting operation.

### BRIEF DESCRIPTION OF DRAWINGS

[Fig. 1] Fig. 1 is a perspective view illustrating a whole structure of a liquid crystal display unit according to an embodiment of the present invention;
[Fig. 2] Fig. 2 is a plan schematic view illustrating a structural example of a unit (partial lighting section) of a light source section in the backlight device illustrated in Fig. 1;
[Fig. 3] Fig. 3 is a plan schematic view illustrating an arrangement structural example of the partial lighting section in the light source section in Fig. 2 and an illuminated light sensor;
[Fig. 4] Fig. 4 is a block diagram illustrating a whole structure of the liquid crystal display unit illustrated in Fig. 1;
[Fig. 5] Fig. 5 is a block diagram illustrating detailed structures of drive and control sections of the light source section illustrated in Fig. 4;
[Fig. 6] Fig. 6 is a timing waveform chart for explaining a drive pulse signal of the light source section;
[Fig. 7] Fig. 7 is a timing waveform chart illustrating a detailed structure of the drive pulse signal illustrated in Fig. 6;
[Fig. 8] Fig. 8 is a timing waveform chart for explaining an example of drive methods of the liquid crystal display panel and the backlight device illustrated in Fig. 1;
[Fig. 9] Fig. 9 is a perspective view for explaining an example of arrangement relations between a picture display region and a partial lighting region;
[Fig. 10] Fig. 10 is a plan schematic view for explaining an arrangement structural example of a light source section and an illuminated light sensor according to Comparative example 1;
[Fig. 11] Fig. 11 is a timing waveform chart for explaining an example of lighting operation of the light source section and light receiving operation of the illuminated light sensor according to Comparative example 1;
[Fig. 12] Fig. 12 is a timing waveform chart illustrating an example of an output signal from the illuminated light sensor according to Comparative example 1;
[Fig. 13] Fig. 13 is a timing waveform chart for explaining an example of lighting operation of a light source section and light receiving operation of an illuminated light sensor according to Comparative example 2;
[Fig. 14] Fig. 14 is a timing waveform chart for explaining another example of lighting operation of the light source section and light receiving operation of the illuminated light sensor according to Comparative example 2;
[Fig. 15] Fig. 15 is a timing waveform chart illustrating an example of an output signal from the illuminated light sensor according to Comparative example 2;
[Fig. 16] Fig. 16 is a flowchart illustrating an example of control operation of the light source section according to the embodiment of the present invention;
[Fig. 17] Fig. 17 is a timing waveform chart illustrating an example of control operation of the light source section according to the embodiment of the present invention; and
[Fig. 18] Fig. 18 is a timing waveform chart illustrating an example of an output signal from the illuminated light sensor according to the embodiment of the present invention.

### BEST MODE(S) FOR CARRYING OUT THE INVENTION

An embodiment of the present invention will be hereinafter described in detail with reference to the drawings.

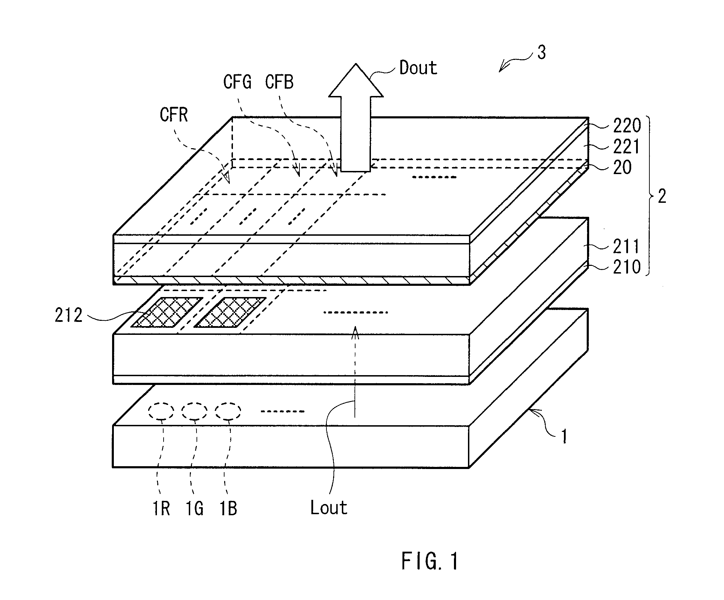

Fig. 1 illustrates a whole structure of a liquid crystal display unit (liquid crystal display unit 3) according to an embodiment of the present invention. The liquid crystal display unit 3 is a so-called transmissive liquid crystal display unit that emits transmitted light as display light Dout. The liquid crystal display unit includes a backlight device 1 as a light source device according to the embodiment of the present invention and a transmissive liquid crystal display panel 2.

The liquid crystal display panel 2 is configured of a transmissive liquid crystal layer 20, a pair of substrates sandwiching the liquid crystal layer 20, that is, a TFT (Thin Film Transistor) substrate 211 as a substrate on the backlight device 1 side and an opposed electrode substrate 221 as a substrate that is opposed to the TFT substrate 211, and polarization plates 210 and 220 respectively layered on the side opposite to the liquid crystal layer 20 with respect to the TFT substrate 211 and the opposed electrode substrate 221.

Further, matrix-like pixels are structured in the TFT substrate 211, and a pixel electrode 212 including a drive element such as a TFT is formed in each pixel.

The backlight device 1 is an additive color mixture type device in which a plurality of color light (in this case, red light, green light, and blue light) are mixed to obtain illuminated light Lout as specific color light (in this case, white light). The backlight device 1 has a light source section (light source section 10 described later) including a plurality of red LEDs 1R, green LEDs 1G, and blue LEDs 1B.

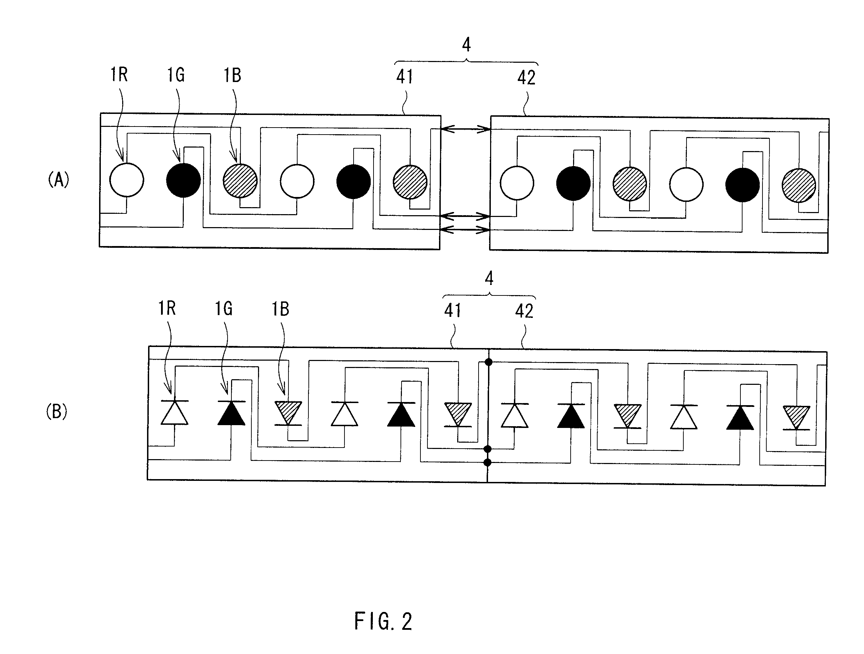

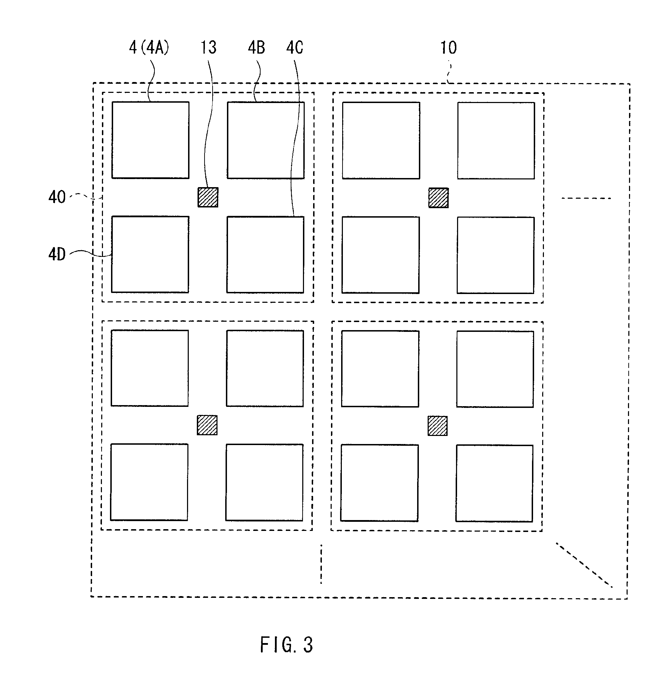

Fig. 2 and Fig. 3 illustrate an example of an arrangement structure of each color LED in the backlight device 1.

As illustrated in Fig. 2(A), unit cells 41 and 42 of a light emitting section are respectively formed from two sets of the red LEDs 1R, two sets of the green LEDs 1G, and two sets of the blue LEDs 1B. A partial lighting section 4 as a unit of the light emitting section is formed from the two unit cells 41 and 42. Further, in each unit cell and between the unit cell 41 and the unit cell 42, each color LED is respectively connected in series. Specifically, as illustrated in Fig. 2(B), an anode and a cathode of each color LED are connected.

The respective partial lighting sections 4 structured as above are arranged in a state of matrix in the light source section 10, for example, as illustrated in Fig. 3. As described later, each of the partial lighting sections 4 is able to be controlled separately. Further, on the light source section 10, one illuminated light sensor 13 is arranged for four partial lighting sections 4 (for example, partial lighting sections 4A to 4D). The illuminated light sensor 13 receives light from the partial lighting sections 4 (after-mentioned illuminated light Lout), and is able to receive light from a region corresponding to the arrangement region of the four partial lighting sections 4 (detection region 40). For the details of the illuminated light sensor 13, a description will be given later.

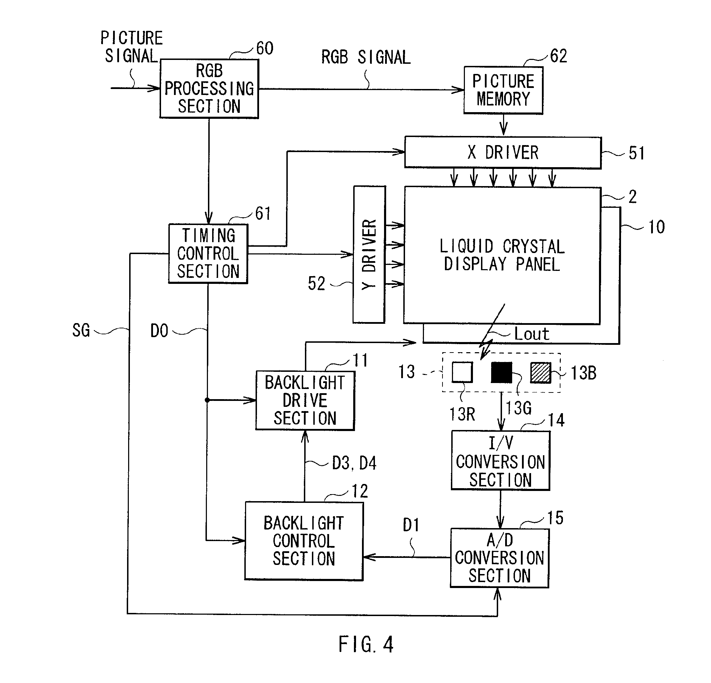

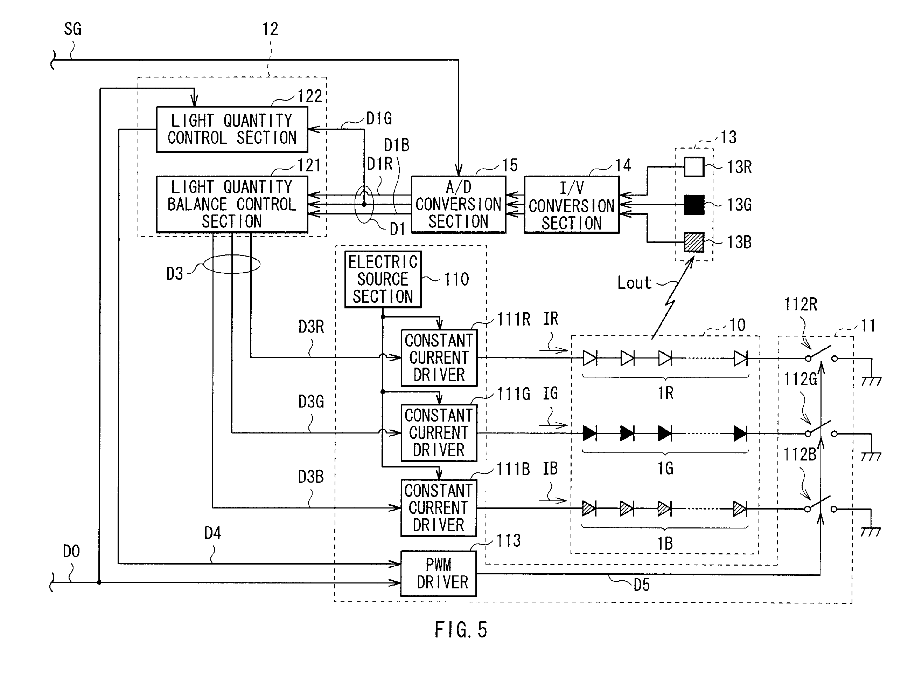

Next, a description will be given in detail of structures of a drive section and a control section of the liquid crystal display panel 2 and the light source section 10 described above with reference to Fig. 4. Fig. 4 illustrates a block configuration of the liquid crystal display unit 3. Additionally, in Fig. 4 (and in Fig. 5 described later), for convenience, only one illuminated light sensor 13 is arranged in the vicinity of the light source section 10.

As illustrated in Fig. 4, a drive circuit for driving the liquid crystal display panel 2 to display a picture is configured of an X driver (data driver) 51 that supplies a drive voltage based on a picture signal to the respective pixel electrodes 212 in the liquid crystal display panel 2, a Y driver (gate driver) 52 that line-sequentially drives the respective pixel electrodes 212 in the liquid crystal display panel 2 along a scanning line (not illustrated), a timing control section (timing generator) 61 that controls the X driver 51 and the Y driver 52, an RGB processing section 60 (signal generator) that processes an external picture signal and generates an RGB signal, and a picture memory 62 as a frame memory that stores the RGB signal from the RGB processing section 60.

Meanwhile, a section that drives and controls lighting operation of the light source section 10 of the backlight device 1 is configured of a backlight drive section 11, a backlight control section 12, the illuminated light sensor 13, an I/V conversion section 14, and an A/D conversion section 15.

The illuminated light sensor 13 receives the illuminated light Lout from the light source section 10 (specifically, the partial lighting sections 4 in the respective detection regions 40 as described above) to obtain a photoreception signal. The illuminated light sensor 13 is configured of a red light sensor 13R that extracts and selectively receives red light out of mixed light (in this case, white light) configured of a mixture of a plurality of color light (in this case, red light, green light, and blue light), a green light sensor 13G that extracts and selectively receives green light out of the mixed light, and a blue light sensor 13B that extracts and selectively receives blue light out of the mixed light.

The I/V conversion section 14 performs I/V (current/voltage) conversion for the photoreception signal for each color obtained by the illuminated light sensor 13, and outputs light receiving data as an analog voltage signal for each color.

The A/D conversion section 15 samples at the given time the light receiving data for each color outputted from the I/V conversion section 14 according to a sampling gate signal SG supplied from the timing control section 61, performs A/D (analogue/digital) conversion for the light receiving data, and outputs light receiving data D1 as a digital voltage signal for each color to the backlight control section 12.

The backlight control section 12 generates and outputs after-mentioned control signals D3 and D4 based on the light receiving data D1 for each color supplied from the A/D conversion section 15, and a control signal D0 supplied from the timing control section 61, and controls drive operation of the backlight drive section 11. Further, for the detailed structure of the backlight control section 12, a description will be given later (Fig. 5).

The backlight drive section 11 time-divisionally drives the light source section 10 to perform lighting operation in units of the partial lighting section 4 based on the control signals D3 and D4 supplied from the backlight control section 12 and the control signal D0 supplied from the timing control section 61. Further, for the detailed structure of the backlight drive section 11, a description will be given later (Fig. 5) as well.

Next, a description will be given of detailed structures of the foregoing backlight drive section 11 and the backlight control section 12 with reference to Fig. 5. Fig. 5 is a block diagram illustrating the detailed structures of the backlight drive section 11 and the backlight control section 12 and structures of the light source section 10, the illuminated light sensor 13, the I/V conversion section 14, and the A/D conversion section 15. The light receiving data D1 is configured of red light receiving data D1R, green light receiving data D1G, and blue light receiving data D1B. The control signal D3 is configured of a red-use control signal D3R, a green-use control signal D3G, and a blue-use control signal D3B. As a matter of convenience, in the figure, the red LED 1R, the green LED 1G, and the blue LED 1B are all connected in series in the light source section 10.

The backlight drive section 11 has an electric source section 110; constant current drivers 111R, 111G, and 111B that respectively supply currents IR, IG, and IB to the anode side of the red LED 1R, the green LED 1G, and the blue LED 1B in the light source section 10 by electric source supply from the electric source section 110 according to the control signal D3 (the red-use control signal D3R, the green-use control signal D3G, and the blue-use control signal D3B) supplied from the backlight control section 12; switching devices 112R, 112G, and 112B that are respectively connected between each cathode of the red LED 1R, the green LED 1G, and the blue LED 1B and earth ground; and a PWM driver 113 that generates and outputs a control signal D5 (pulse signal) to the switching devices 112R, 112G, and 112B based on the control signal D4 supplied from the backlight control section 12 and the control signal D0 supplied from the timing control section 61, and PWM-controls the switching devices 112R, 112G, and 112B respectively.

The backlight control section 12 has a light quantity balance control section 121 and a light quantity control section 122. The light quantity balance control section 121 respectively generates and outputs the control signal D3 (the red-use control signal D3R, the green-use control signal D3G, and the blue-use control signal D3B) to the constant current drivers 111R, 111G, and 111B based on the light receiving data D1 (the red light receiving data D1R, the green light receiving data D1G, and the blue light receiving data D1B) supplied from the A/D conversion section 15, and thereby the light quantity balance control section 121 performs control so that the light emission quantity of the illuminated light Lout is changed while color balance (white balance of white light) of the illuminated light Lout from the light source section 10 is kept constant. Further, the light quantity control section 122 generates and outputs the control signal D4 to the PWM driver 113 based on the green light receiving data D1G out of the light receiving data D1 supplied from the A/D conversion section 15 and the control signal D0 supplied from the timing control section, and thereby the light quantity control section 122 performs control so that the light emission quantity of the illuminated light Lout from the light source section 10 is changed.

The backlight drive section 11 and the backlight control section 12 correspond to a specific example of "drive means" in the present invention. The A/D conversion section 15 corresponds to a specific example of "sampling means" in the present invention. The illuminated light sensor 13 corresponds to a specific example of "photoreception device" in the present invention.

Next, a description will be given in detail of operations of the backlight device 1 and the liquid crystal display unit 3 of this embodiment having the foregoing structures.

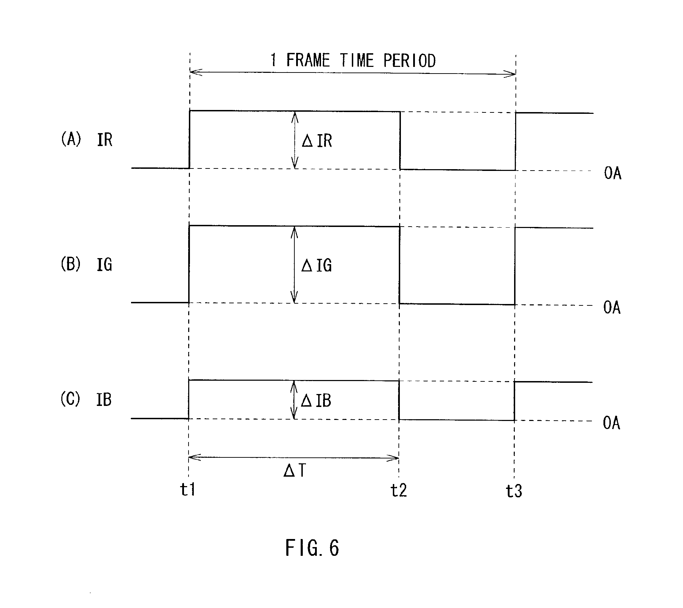

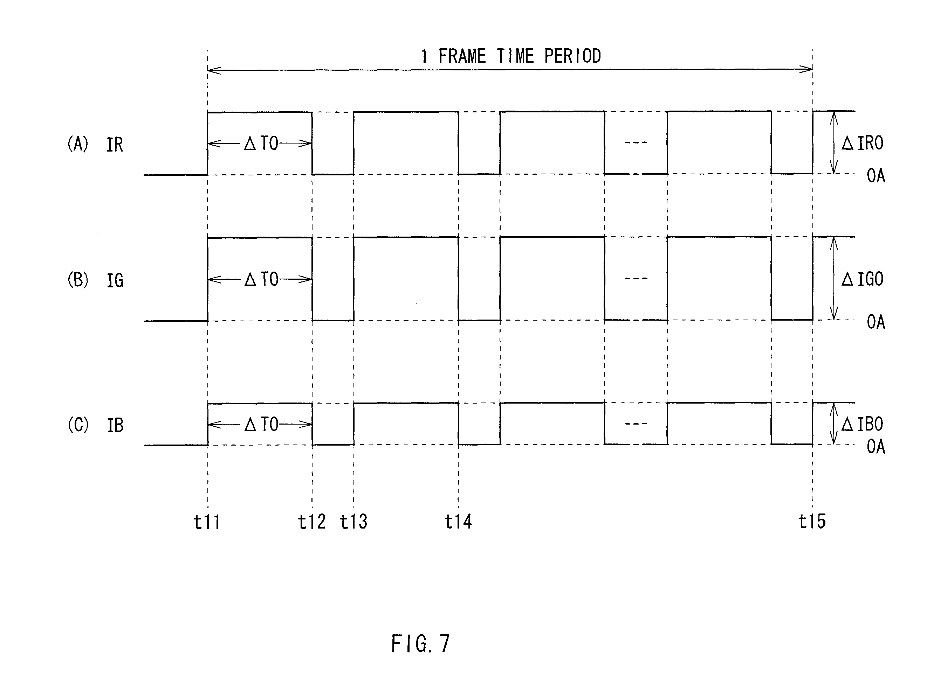

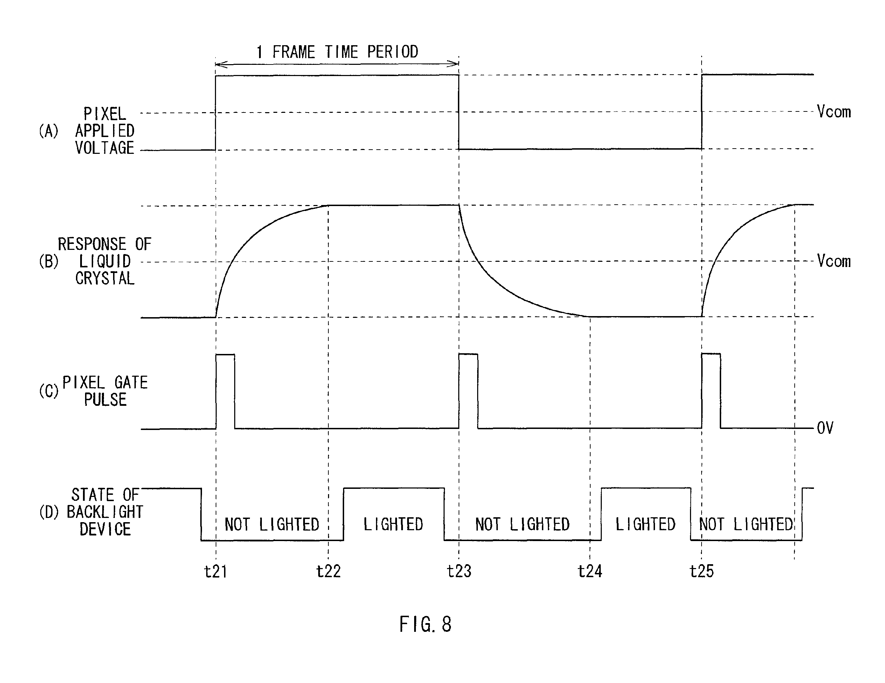

First, a description will be given of basic operations of the backlight device 1 and the liquid crystal display unit 3 of this embodiment with reference to Fig. 1 to Fig. 8. Fig. 6 and Fig. 7 are a timing waveform chart illustrating lighting operation in the light source section 10 of the backlight device 1. Figs. 6(A) and 7(A) illustrate the current IR flowing through the red LED 1R, Figs. 6(B) and 7(B) illustrate the current IG flowing through the green LED 1G, and Figs. 6(C) and 7(C) illustrate the current IB flowing through the blue LED IB. In addition, Fig. 8 illustrates a timing waveform chart schematically illustrating operation of the whole liquid crystal display unit 3. Fig. 8(A) illustrates a voltage (pixel applied voltage and drive voltage) that is applied from the X driver 51 to one pixel electrode 212 in the liquid crystal display panel 2. Fig. 8(B) illustrates response of liquid crystal molecules (actual potential state in the pixel electrode 212). Fig. 8(C) illustrates a voltage (pixel gate pulse) that is applied from the Y driver 52 to a gate of the TFT device in the liquid crystal display panel 2.

In the backlight device 1, in the case where the switching devices 112R, 112G, and 112B respectively become on-state in the backlight drive section 11, the currents IR, IG, and IB are respectively flown from the constant current drivers 111R, 111G, and 111B into the red LED 1R, the green LED 1G, and the blue LED 1B in the light source section 10. Thereby, red light emission, green light emission, and blue light emission are respectively initiated, and the illuminated light Lout as mixed light is emitted.

At this time, the control signal D0 is supplied from the timing control section 61 to the backlight drive section 11. A control signal D5 based on the control signal D0 is respectively supplied from the PWM driver 113 in the backlight drive section 11 to the switching devices 112R, 112G, and 112B. Thereby, the switching devices 112R, 112G, and 112B become on-state at the timing according to the control signal D0. Lighting time periods of the red LED 1R, the green LED 1G, and the blue LED 1B are synchronized with the above. In other words, the red LED 1R, the green LED 1G, and the blue LED 1B are PWM-driven by time-divisional drive using the control signal D5 as a pulse signal.

Further, at this time, the illuminated light sensor 13 receives the illuminated light Lout from the light source section 10. Specifically, in the red light sensor 13R, the green light sensor 13G, and the blue light sensor 13B in the illuminated light sensor 13, each color light out of the illuminated light Lout from the light source section 10 is respectively extracted by a photodiode for each color, and a current according to the light quantity of each color light is generated. Thereby, light receiving data of a current value is supplied to the I/V conversion section 14. Additionally, the light receiving data of the current value for each color is respectively converted to light receiving data of an analog voltage value by the I/V conversion section 14. Further, in the A/D conversion section 15, the light receiving data of the analog voltage value for each color is sampled at the given time according to the sampling gate signal Sg supplied from the timing control section 61, and is converted to the light receiving data D1R, D1G, and D1B of the digital voltage value.

Here, in the backlight control section 12, the control signals D3R, D3G, and D3B are respectively supplied from the light quantity balance control section 121 to the constant current drivers 111R, 111G, and 111B based on the light receiving data D1R, D1G, and D1B for each color supplied from the A/D conversion section 15, and thereby sizes ΔIR, ΔIG, and ΔIB of the currents IR, IG, and IB, that is, light emission luminance of the LEDs 1R, 1G, and 1B is adjusted so that luminance and chromaticity (color balance) of the illuminated light Lout are kept constant (refer to Figs. 6(A) to 6(C)). Further, in the light quantity control section 122, the control signal D4 is generated based on the light receiving data D1G out of the light receiving data D1R, D1G, and D1B for each color supplied from the A/D conversion section 15, and the control signal D4 is supplied to the PWM driver 113, and thereby on-time period of the switching devices 112R, 112G, and 112B, that is, lighting time period ΔT of the LEDs 1R, 1G, and 1B for each color is adjusted (refer to Figs. 6(A) to 6(C)). Accordingly, based on the illuminated light Lout from the light source section 10, the sizes ΔIR, ΔIG, and ΔIB of the currents IR, IG, and IB (light emission luminance of the LEDs 1R, 1G, and 1B) and the lighting time period are controlled, and thereby the light emission quantity of the illuminated light Lout is controlled in units of the partial lighting section 4.

In addition, the light quantity control section 122 herein inputs only D1G out of the control signals D1R, D1G, and D1B, since human visibility of green light is highest. However, other control signals D1R and D1B may be inputted. Further, in Figs. 6(A) to 6(C), only one pulse signal (lighting time period: ΔT) exists per one frame time period. In reality, as illustrated in Figs. 7(A) to 7(C), a plurality of pulse signals (pulse signals per lighting time period: ΔT0, for example, a pulse signal in time period from timing t11 to timing t12, a pulse signal in time period from timing t13 to timing t14 and the like) exist per one frame time period (unit display drive time period).

Meanwhile, in the whole liquid crystal display unit 3 of this embodiment, the illuminated light Lout from the light source section 10 of the backlight device 1 is modulated in the liquid crystal layer 20 by a drive voltage (pixel applied voltage) to the pixel electrode 212 that is outputted from the X driver 51 and the Y driver 52 based on the picture signal, and the modulated light is outputted from the liquid crystal display panel 2 as display light Dout. As described above, the backlight device 1 functions as a backlight (illuminating device for liquid crystal) of the liquid crystal display unit 3, and thereby picture display by the display light Dout is performed.

Specifically, for example, as illustrated in Fig. 8(C), a pixel gate pulse is applied from the Y driver 52 to a gate of the TFT devices of one horizontal line in the liquid crystal display panel 2. In addition, as illustrated in Fig. 8(A), the pixel applied voltage based on the picture signal is applied from the X driver 51 to the pixel electrodes 212 of one horizontal line. Here, as illustrated in Fig. 8(B), actual potential response (liquid crystal response) of the pixel electrode 212 to the pixel applied voltage is delayed (while the pixel applied voltage is started up in timing t21, the actual potential is started up in timing t12). The backlight device 1 becomes in a state of lighting in the time period from the timing t22 to timing t23 in which the actual potential is equal to the pixel applied voltage, and thereby picture display based on the picture signal is performed in the liquid crystal display unit 3. Further, in Fig. 8, the time period from the timing t21 to the timing t23 corresponds to one horizontal time period (1 frame time period). In subsequent one horizontal time period from the timing t23 to timing t25, operation similar to that of one horizontal time period from the timing t21 to the timing t23 is performed, except that the pixel applied voltage is inverted with respect to a common potential Vcom to prevent a liquid crystal ghost image or the like.

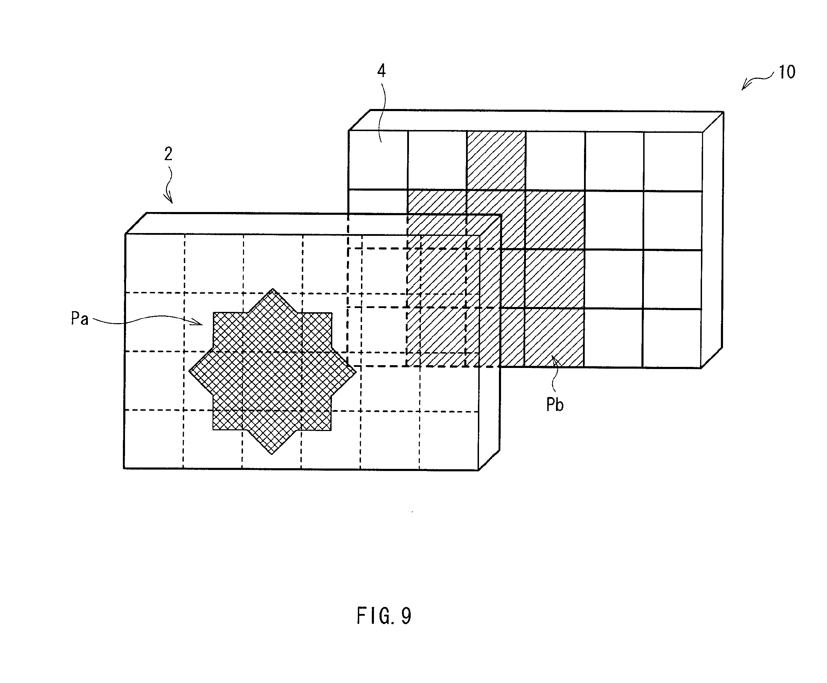

Further, in this liquid crystal display unit 3, the control signal D0 is supplied from the timing control section 61 to the PWM driver 113 in the backlight drive section 11 by using the signal supplied from the RGB processing section 60 (signal based on the picture signal). Thus, for example, as illustrated in Fig. 9, in the light source section 10, operation in which only the partial lighting sections 4 in a region corresponding to a picture display region (region in which a display picture Pa is displayed) in which light is emitted at given luminance or more out of the picture display region in the liquid crystal display panel 2 are lighted to form a partial lighting region Pb is enabled.

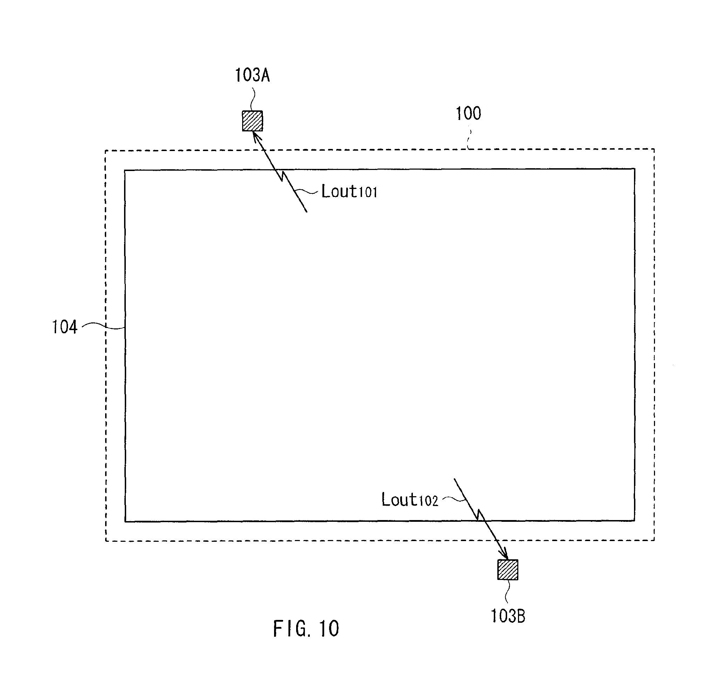

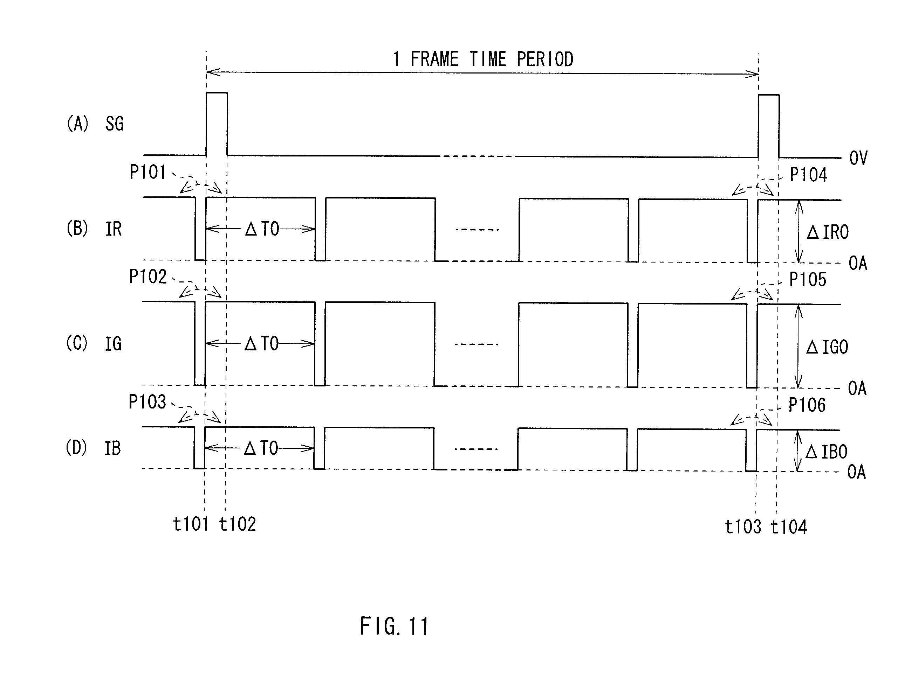

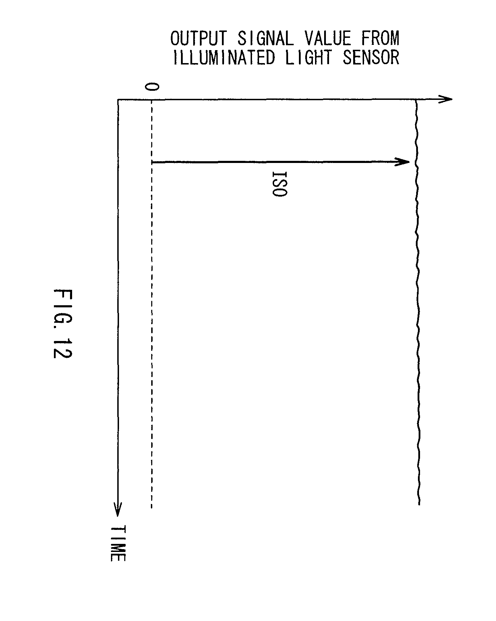

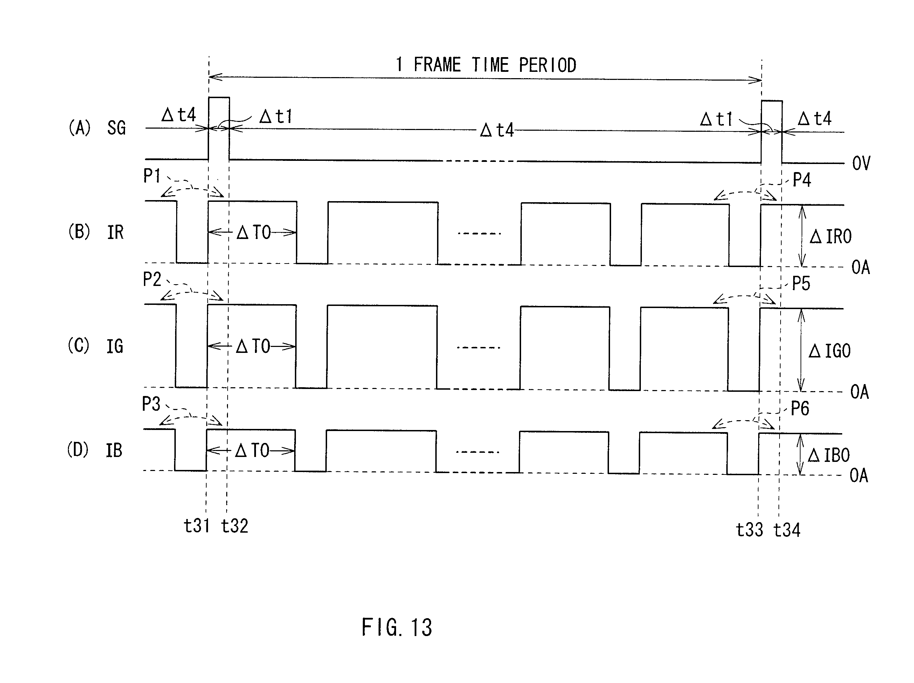

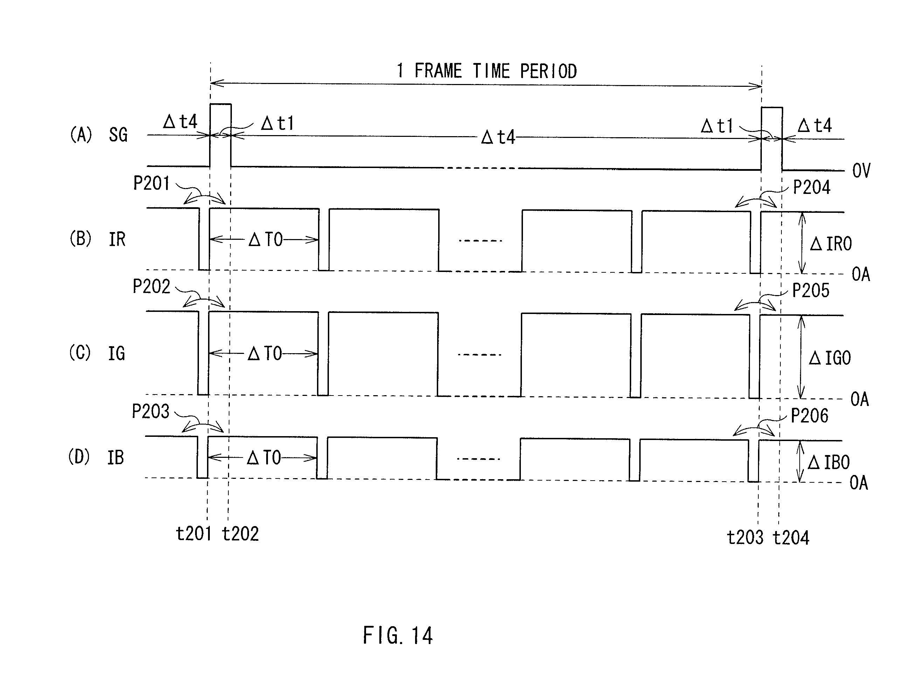

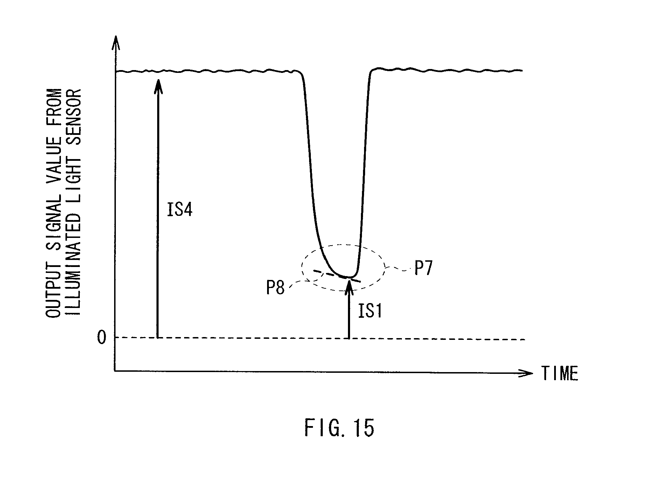

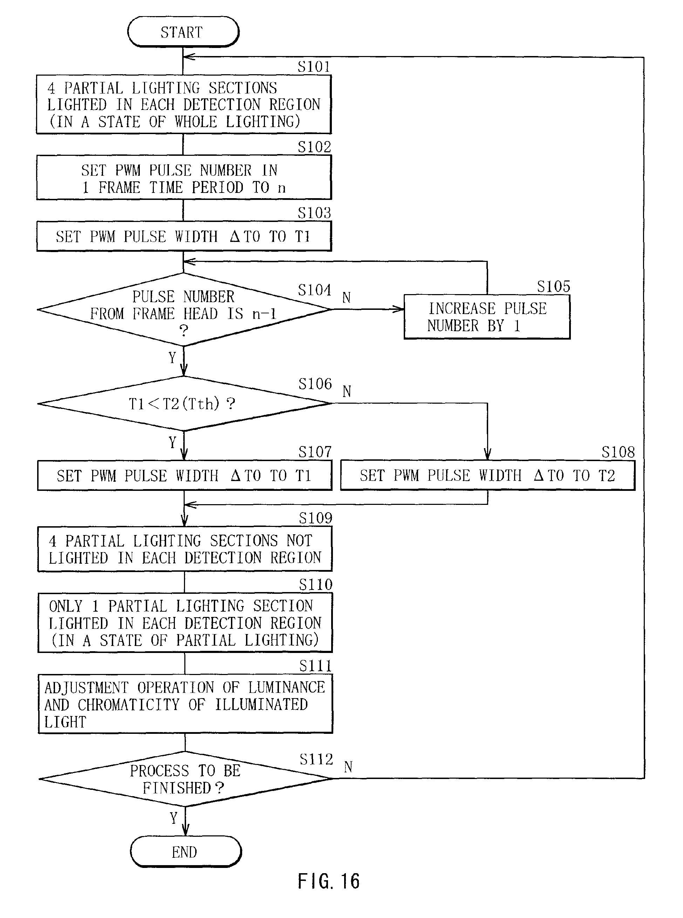

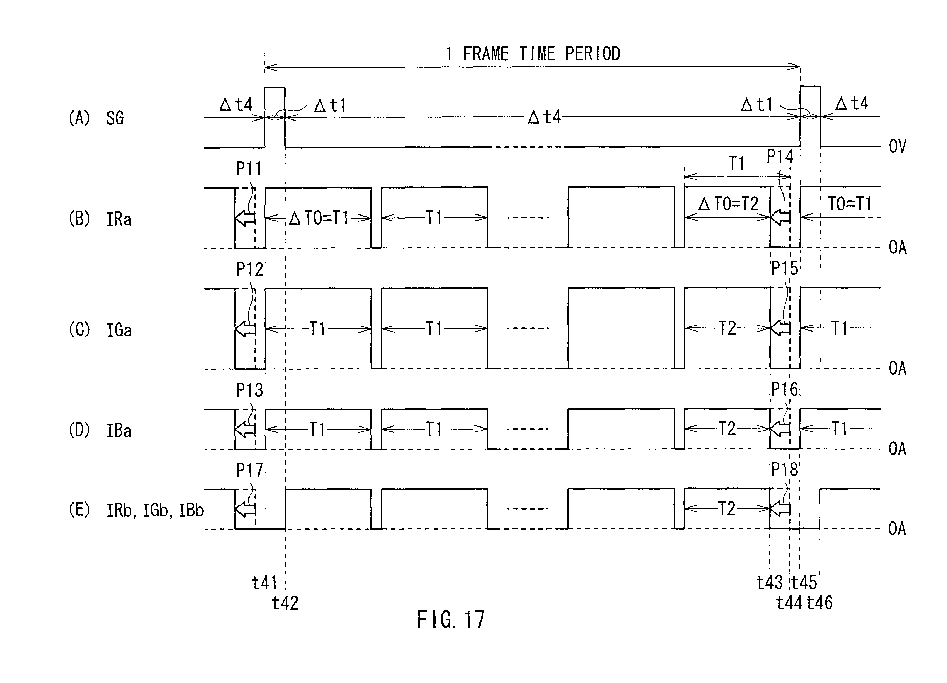

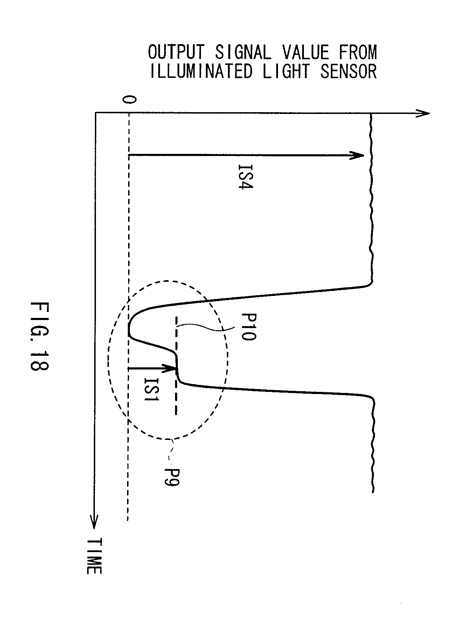

Next, a description will be given in detail of a control operation of characteristic part of the present invention in comparison to comparative examples with reference to Fig. 10 to Fig. 18 in addition to Fig. 1 to Fig. 9. Here, Fig. 10 illustrates an arrangement structure of a light source section and a display light sensor in a conventional backlight device according to Comparative example 1. Fig. 11 illustrates lighting operation in the backlight device according to Comparative example 1. Fig. 12 illustrates a timing waveform of an output signal (photoreception signal) obtained by an illuminated light sensor in Comparative example 1. Fig. 13 and Fig. 14 illustrate lighting operation in a conventional backlight device according to Comparative example 2. Fig. 15 illustrates a timing waveform of an output signal (photoreception signal) obtained by an illuminated light sensor in Comparative example 2. Fig. 16 is a flowchart illustrating an example of control operation of the light source section 10 in the backlight device 1 of this embodiment. Fig. 17 illustrates an example of lighting operation in the backlight device 1 of this embodiment. Fig. 18 illustrates a timing waveform of an output signal (photoreception signal) obtained by the illuminated light sensor 13 in this embodiment. Further, in Fig. 17, Figs. 17(B) to 17(D) respectively illustrate currents IRa, IGa, and IBa in a partial lighting section that is also lighted in the after-mentioned partial lighting time period, and Fig. 17(E) illustrates currents IRb, IGb, and IBb in a partial lighting section that is not lighted in the partial lighting time period.

First, the backlight device according to Comparative example 1 has, for example, as illustrated in Fig. 10, a light source section 100 including a single lighting section 104. On the periphery of the light source section 100, display light sensors (in Fig. 10, two display light sensors 103A and 103B) are arranged, and the display light sensors receive illuminated light (illuminated lights Lout101 and Lout102) from the single lighting section 104. Thus, as illustrated in Fig. 11, an absolute value of a pulse signal indicating sizes of the currents IR, IG, and IB is always constant unless set values of current values ΔIR0, ΔIG0, and ΔIB0 are changed (Figs. 11(B) to 11(D). Thus, in sampling (detecting) a photoreception signal obtained by the display light sensors 103A and 103B, for example, in time period from timing t101 to timing t102 and time period from timing t103 to timing t104 by, for example, a sampling gate signal SG illustrated in Fig. 11(A) for adjusting light emission luminance and chromaticity of the single lighting section 104, as illustrated in referential symbols P101 to P106 in the figure, even if each duty ratio of each pulse signal is large (light emission luminance of the lighting section 104 is high), the respective pulse signals do not interfere with each other. Accordingly, for example, as illustrated in Fig. 12, the output signal (photoreception signal) from the display sensors 103A and 103B always becomes a constant value IS0 without relation to sampling timing.

Meanwhile, the backlight device according to Comparative example 2 has a light source section and an illuminated light sensor similar to the light source section 10 and the illuminated light sensor 13 of this embodiment illustrated in Fig. 3, for example. The backlight device according to Comparative example 2 is able to perform partial lighting operation by using a plurality of partial lighting sections, each of which is controlled separately. Further, as illustrated in Fig. 13, in a state of normal partial lighting, all four partial lighting sections in the detection region 40 are lighted (in a state of whole lighting: for example, in a state of time period until timing t31, time period from timing t32 to timing t33, and time period on and after timing t34 (whole lighting time period Δt4)). Meanwhile, for example, as time period from the timing t31 to the timing t32 and time period from the timing t33 to the timing t34, in sampling a photoreception signal by the sampling gate signal SG for adjusting luminance and chromaticity of illuminated light, only part of the partial lighting sections in the detection region 40 (in this case, one partial lighting section) is lighted (in a state of partial lighting: in a state of partial lighting time period Δt1), and light from the partial lighting section is sampled. Therefore, a size of a photoreception signal obtained by the illuminated light sensor 13 in the whole lighting time period Δt4 is different from that in the partial lighting time period Δt1 (refer to a signal value IS4 (signal value obtained in the whole lighting time period Δt4) and a signal value IS1 (signal value obtained in the partial lighting time period Δt1) in Fig. 15 described later), and thus in the case where the duty ratio of a pulse signal is not much large (in the case where the light emission luminance of the partial lighting section is not much high), as illustrated in referential symbols P1 to P6 in Fig. 13, the pulse signal in the partial lighting time period Δt1 and the pulse signal in the whole lighting time period Δt4 do not interfere with each other and no signal value shift is generated. However, in the case where the duty ratio of the pulse signal is large (in the case where the light emission luminance of the partial lighting section is high), for example, as illustrated in referential symbols P201 to P206 in Fig. 14, the pulse signal in the partial lighting time period Δt1 and the pulse signal in the whole lighting time period Δt4 interfere with each other in some cases (refer to the section surrounded by referential symbol P7 in Fig. 15). In such a case, for example, as indicated by referential symbol P8 in Fig. 15, signal values of photoreception signals differ according to sampling timing of the obtained photoreception signals, and the detection precision is lowered. If the detection precision is lowered, luminance change and chromaticity change of the illuminated light are hardly inhibited.

Therefore, in the backlight device 1 of this embodiment, for example, as illustrated in Fig. 16, control operation for the respective partial lighting sections 4 in the light source section 10 is performed. Specifically, first, in the whole lighting time period Δt4 in one frame time period (for example, timing t42 in Fig. 17), all four partial lighting sections 4 in the respective detection region 40 in the light source section 10 become in a state of lighting (in a state of whole lighting) (step S101 of Fig. 16). For example, in the timing control section 61, PWM pulse number as the number of pulse signals included in one frame time period (pulse number of the control signal D0 supplied to the PWM driver 113) is set to n (n is an integer number of 2 or more) (step S102). In addition, as illustrated in Figs. 17(B) to 17(E), a PWM pulse width ΔT0 (pulse width of the control signal D0 corresponding to the lighting time period ΔT0 of the respective partial lighting sections 4 illustrated in Fig. 7) is set to T1 (step S103). Additionally, the PWM pulse width T1 corresponds to the lighting time period of the respective partial lighting sections 4. For ease of explanation, a description will be given of a case of a constant lighting time period (case that the light emission luminance of the respective partial lighting sections 4 is constant).

Next, the light quantity control section 122 in the backlight control section 12 counts the PWM pulse number in the control signal D0 supplied from the timing control section 61 by, for example, a counter or the like, and thereby determines whether or not the pulse number from the head of the frame is (n-1) as needed (step S104). In the case where the pulse number from the head of the frame is not (n-1) (step S104: N), the pulse number is increased by 1 (step S105), and the procedure is returned back to step S104. Meanwhile, in the case where the pulse number from the head of the frame is (n-1) (step S104: Y), it means that the next PWM pulse is the last pulse signal in one frame time period. In other words, it means that the next PWM pulse is the pulse signal (last pulse signal) generated immediately before the transition time period from the whole lighting time period Δt4 to the partial lighting time period Δt1 that firstly exists in the next frame time period (for example, time period from timing t41 to the timing t42 and time period from timing t45 to timing t46 in Fig. 17).

Next, the light quantity control section 122 determines whether or not the PWM pulse width T1 corresponding to the lighting time period of the respective partial lighting sections 4 is smaller than a pulse width T2 as a given threshold value Tth based on the control signal D0 supplied from the timing control section 61 (step S106). In the case where the PWM pulse width T1 is smaller than the pulse width T2 (Tth), the light quantity control section 122 determines that the duty ratio of the last pulse signal is not much large (light emission luminance of the partial lighting section 4 is not much high) and thus the pulse signal in the partial lighting time period Δt1 and the pulse signal in the whole lighting time period Δt4 do not interfere with each other. Thus, the light quantity control section 122 generates the control signal D4 and outputs the control signal D4 to the PWM driver 113 so that the pulse width of the last pulse signal remains T1 (step S107). Meanwhile, in the case where the pulse width T1 is larger than the pulse width T2 (Tth), the light quantity control section 122 determines that the duty ratio of the last pulse signal is large (light emission luminance of the partial lighting section 4 is high) and thus the pulse signal in the partial lighting time period Δt1 and the pulse signal in the whole lighting time period Δt4 interfere with each other. Thus, the light quantity control section 122 generates the control signal D4 and outputs the control signal D4 to the PWM driver 113 so that the pulse width of the last pulse signal becomes the threshold value T2 (step S108). Therefore, for example, as illustrated in referential symbols P11 to P18 in Fig. 17, the width T0 of the pulse signal of the last pulse is forcefully decreased from T1 to T2. Thereby, for example, as indicated by referential symbol P9 in Fig. 18, interference between the photoreception signal (signal value: IS1) in the partial lighting time period Δt1 and the photoreception signal (signal value: IS4) in the whole lighting time period Δt4 is avoided. In result, as indicated by referential symbol P10 in Fig. 18, the output signal (photoreception signal) from the illuminated light sensor 13 is always the constant value IS1 not depending on time.

Next, all four partial lighting sections 4 in the respective detection regions 40 become once in a state of non-lighting (for example, time period from timing t43 to the timing t45 in Fig. 17) (step S109). After that, only one of four partial lighting sections in the respective detection regions 40 becomes in a state of lighting (for example, the partial lighting time period Δt1 such as time period from the timing t41 to the timing t42 and time period from the timing t45 to the timing t46 in Fig. 17), resulting in a state of partial lighting (step S110). In such a state of partial lighting, the photoreception signal obtained by the illuminated light sensor 13 in the respective detection regions 40 is sampled (detected). Based on the sampled light receiving data, as described above, adjustment operation of luminance and chromaticity of the illuminated light Lout is performed by the light quantity balance control section 121 and the light quantity control section 122 in the backlight control section 12 (step S111). In addition, after that, determination is made whether or not the whole processing is to be finished (step S112). In the case where determination is made that the whole processing is not to be finished (step S112:N), the procedure is returned back to step S101 and the foregoing processing is repeated. Meanwhile, in the case where determination is made that the whole processing is to be finished (step S112:Y), the whole processing is finished.

As described above, in this embodiment, the light source section 10 is time-divisionally driven by a pulse signal so that the whole lighting time period Δt4 and the partial lighting time period Δt1 are mixed along time base. In addition, light from the light source section 10 is received by the illuminated light sensor 13, the width of the pulse signal (last pulse signal) generated immediately before the transition time period from the whole lighting time period Δt4 to the partial lighting time period Δt1 is set to the given threshold value T2 (Tth) or less, and the photoreception signal obtained by the illuminated light sensor 13 is sampled at the timing in the partial lighting time period Δt1. Thus, even if the light emission luminance of the partial lighting section 4 is set high (even if the width of the foregoing last pulse signal is set to be wider than the given threshold value T2 (Tth)), interference between the photoreception signal obtained in the whole lighting time period Δt4 and the photoreception signal obtained in the last partial lighting time period Δt1 is able to be avoided. Therefore, the signal value of the photoreception signal in the partial lighting time period Δt1 is able to be almost constant not depending on sampling timing in the partial lighting time period Δt1. Accordingly, in the light source device performing partial lighting operation, detection precision of illuminated light is able to be improved.

Further, the light emission quantities of the respective partial lighting sections 4 are respectively kept constant based on the sampled photoreception signal in the partial lighting time period Δt1 Thus, the light emission quantities of the respective partial lighting sections 4 are able to be respectively controlled based on the photoreception signal in the partial lighting time period Δt1 whose value is kept almost constant not depending on sampling timing. Therefore, precision to keep the light emission quantity constant is able to be improved.

Further, such a backlight device 1 is used as a backlight (illuminating device for liquid crystal) of the liquid crystal display unit 3. Thus, in performing picture display on only part of the display screen, luminance change and chromaticity change are able to be also inhibited in the display light Dout radiated from the liquid crystal display panel 2. Accordingly, image quality of the display picture is able to be improved not depending on timing of detecting the illuminated light Lout.

The present invention has been described with reference to the embodiment. However, the present invention is not limited to the foregoing embodiment, and various modifications may be made.

For example, in the foregoing embodiment, a description has been given of a case that the threshold value T2 (Tth) of the width ΔT of the pulse signal is constant. However, the threshold value Tth may be a variable value. Specifically, for example, it is possible that setting is made so that as the frequency of a plurality of pulse signals is increased, the threshold value Tth is decreased. In this case, it is possible to address a case that the frequency of the plurality of pulse signals is changed.

Further, in the foregoing embodiment, a description has been given of a case that the light emission quantities of the respective partial lighting sections 4 in the detection region 40 are respectively kept constant based on the sampled photoreception signal in the partial lighting time period Δt1. However, it is possible that control is performd so that only the light emission quantity of a partial lighting section that is lighted in the partial lighting time period Δt1 is kept constant based on the sampled photoreception signal in the partial lighting time period Δt1, and the partial lighting section that is lighted in the partial lighting time period Δt1 is circulated, for example, in the detection region 40. In this case, again, the light emission quantity of the partial lighting section that is lighted in the partial lighting time period Δt1 is respectively controlled based on the photoreception signal in the partial lighting time period Δt1 whose value is kept almost constant not depending on sampling timing, and thus precision to keep the light emission quantity constant is able to be improved. Further, since the partial lighting section as a control target of the light emission quantity is circulated in the detection region 40 or the like as described above, light emission quantities of the all partial lighting sections 4 are controlled based on their own illuminated light. Accordingly, fine light emission quantity control for the respective partial lighting sections 4 is enabled, and precision to keep the light emission quantity constant as the whole light source section 10 is able to be more improved.

Further, in the foregoing embodiment, the description has been given of the case that only one partial lighting time period Δt1 is provided in one frame time period. However, a plurality of partial lighting time periods Δt1 may be provided in one frame time period. On the contrary, one partial lighting time period Δt1 may be provided in a plurality of frame time periods. Further, the position of the partial lighting time period Δt1 in one frame time period is not limited to the head in one frame time period.

Further, in the foregoing embodiment, the description has been given of the case that four partial lighting sections 4 are provided in one detection region 40. However, the number of partial lighting sections 4 is not limited thereto. Further, in the foregoing embodiment, the description has been given of the case that the all four partial lighting sections 4 are lighted in the whole lighting time period Δt4, and only one partial lighting section 1 is lighted in the partial lighting time period Δt1. However, the number thereof is not limited thereto, and it is enough that the number of partial lighting sections 4 that are lighted in the whole lighting time period is larger than the number of partial lighting sections 4 that are lighted in the partial lighting time period.

Further, in the foregoing embodiment, the description has been given of the case that the backlight drive section 11 is controlled by using the light receiving data from one illuminated light sensor 13. However, it is possible that a plurality of illuminated light sensors are provided in a position different from each other with respect to, for example, the light source section 10, an average value of the light receiving data from the plurality of illuminated light sensors or the like is obtained, and thereby the backlight drive section 11 is controlled.

Further, in the foregoing embodiment, the description has been given of the case that the light source section 10 is configured of the red LED 1R, the green LED 1G, and the blue LED 1B. However, the light source section 10 may be configured of an LED emitting other color light in addition thereto (or instead thereof). In the case where the light source section 10 is configured of different four or more color light, it is possible that the color reproduction range is expanded, and a wider variety of colors is expressed.

Further, in the foregoing embodiment, the description has been given of the additive color mixture type backlight device 1 in which the light source section 10 includes the plurality of red LEDs 1R, the plurality of green LEDs 1G, and the plurality of blue LEDs 1B, and the illuminated light Lout as specific color light (white color) is obtained by mixing the plurality of color light (red light, green light, and blue light). However, it is possible that the light source section is configured of one type of LED to structure a backlight device emitting homochromatic color illuminated light. In this case, change of luminance of illuminated light is able to be more decreased with a simple structure as well.

Further, in the foregoing embodiment, the description has been given of the case that the liquid crystal display unit 3 is the transmissive liquid crystal display unit including the backlight device 1. However, it is possible that a front light device is structured by the light source device of the present invention to obtain a reflective liquid crystal display unit.

Further, the light source device of the present invention is not only applied to the illuminating device for the liquid crystal display unit, but is able to be also applied to other light source device such as a lighting equipment.

## Claims

1. A light source device **characterized by** comprising:
a light source section having a plurality of partial lighting sections, each of the partial lighting sections being controlled separately;
a drive means for time-divisionally driving the light source section with a pulse signal so that a whole lighting time period and a partial lighting time period are mixed along time base, all of the partial lighting sections being lighted in the whole lighting time period, only one part of the partial lighting sections being lighted in the partial lighting time period, the drive means performing control so that a width of the pulse signal generated immediately before a transition from the whole lighting time period to the partial lighting time period are equal to or less than a given threshold value;
a photoreception device receiving light from the light source section; and
a sampling means for sampling, at a timing in the partial lighting time period, a photoreception signal obtained by the photoreception device.

2. The light source device according to claim 1, **characterized in that** the drive means performs control so that a light emission quantity of each of the partial lighting sections is respectively kept constant based on the photoreception signal sampled by the sampling means in the partial lighting time period.

3. The light source device according to claim 1, **characterized in that** the drive means performs control so that a light emission quantity of the one part of the partial lighting sections is respectively kept constant based on the photoreception signal sampled by the sampling means in the partial lighting time period, and drives the light source section so that the one part of the partial lighting sections circularly travels in the plurality of partial lighting sections.

4. The light source device according to claim 1, **characterized in that** the drive means performs configuration so that the threshold value decreases as a frequency of the pulse signal increases.

5. The light source device according to claim 1, applied to a liquid crystal panel that modulates incident light based on a picture signal, **characterized in that** the light source device is configured as a lighting device for liquid crystal that emits light from each of the partial lighting sections as the incident light to the liquid crystal panel.

6. The light source device according to claim 5, **characterized in that** the drive means drives the light source section so that the partial lighting time period is arranged at the head of a unit of display drive time period.

7. A liquid crystal display unit with an illuminating means for emitting light and with a liquid crystal panel that modulates the light emitted from the illuminating means based on a picture signal, **characterized in that** the illuminating means comprises:
a light source section having a plurality of partial lighting sections, each of the partial lighting sections being controlled separately;
a drive means for time-divisionally driving the light source section with a pulse signal so that a whole lighting time period and a partial lighting time period are mixed along time base, all of the partial lighting sections being lighted in the whole lighting time period, only one part of the partial lighting sections being lighted in the partial lighting time period, the drive means performing control so that a width of the pulse signal generated immediately before a transition from the whole lighting time period to the partial lighting time period are equal to or less than a given threshold value;
a photoreception device receiving light from the light source section; and
a sampling means for sampling, at a timing in the partial lighting time period, a photoreception signal obtained by the photoreception device.
